# EUROPEAN PATENT SPECIFICATION

(11) **EP 0 484 752 B1**
(45) Date of publication and mention of the grant of the patent: **02.01.1997**
(21) Application number: 91118134.5
(22) Date of filing: 24.10.1991
(51) Int. Cl.: G03F 7/027, G03F 7/075

(54) **Photopolymerizable composition and photosensitive lithographic printing plate**
Photopolymerisierbare Zusammensetzung und lichtempfindliche lithographische Druckplatte
Composition photopolymérisable et planche d'impression lithographique photosensible

(30) Priority: 24.10.1990 JP 287751/90
(43) Date of publication of application: 13.05.1992
(73) Proprietor: NIPPON PAINT CO., LTD., Osaka-shi, Osaka-fu (JP)
(72) Inventor: Hase, Takakazu, Nishinomiya-shi, Hyogo-ken (JP); Arimatsu, Seiji, Hirakata-shi, Osaka-fu (JP)
(74) Representative: Hansen, Bernd, Dr. Dipl.-Chem.

(56) References cited:
- DE-A- 2 441 315
- DERWENT ACCESSION No. 84-309 050 Questel Telesystems (WPIL), Derwent Publications Ltd., London

## Description

### FIELD OF THE INVENTION

The present invention relates to a photopolymerizable composition, and a photosensitive lithographic printing plate having excellent adhesion between a substrate and a cured film, printing durability, storage stability, etc.

### BACKGROUND OF THE INVENTION

Offset lithographic printing plates are classified roughly into a diazo-type and a photopolymerization-type. The photopolymerization type one utilizing chain reaction of unsaturated double bond is superior in toughness of the film in comparison with the diazo type one and it can be easily improved in sensitivity. Therefore, it has recently been applied to high printing durability lithographic printing plate, high sensitivity lithographic printing plate which is capable of imaging by a visible ray (particularly, laser), frequently.

However, the photosensitive lithographic printing plate to which the photopolymerizable composition is applied is improved in toughness of a photocured film itself, but has a drawback of poor adhesion. Particularly, in the case of an aluminum substrate, when chemical conversion treatment (e.g. silicate treatment, etc.) is sufficiently conducted after anodizing treatment in order to improve hydrophilic nature and water retention characteristic, adhesion between a substrate and a photosensitive layer becomes insufficient, which results in a printing plate having low printing durability. To the contrary, in order to avoid the above drawback, when chemical conversion treatment (e.g silicate treatment, etc.) is not sufficiently conducted, hydrophilic nature and water retention characteristic of the non-printing area is deteriorated, whereby, stain is arisen during printing, or chemical action is caused between the photosensitive layer and the substrate surface during storage, whereby, non-cured film which is not removed by development is remained at the non-printing area after image forming.

In order to solve these problems, for example, in Japanese Patent Kokai No. 52002/1976, there is disclosed a method comprising incorporating an aminoalkoxy silane compound into a photosensitive layer of a printing plate in which o-naphthoquinone diazide derivative is used and, in Japanese Patent Kokai No. 192250/1984, there is disclosed a method comprising providing a non-photosensitive interlayer containing a silane coupling agent between a substrate and a photosensitive layer.

However, the former aminoalkoxy silane compound is effective for the photosensitive layer of the printing plate in which o-naphthoquinone diazide derivative is used, but exhibits no effect to a photopolymerizable photosensitive composition comprising a polymerizable compound having an ethylenically unsaturated double bond. Further, in the latter method comprising providing the non-photosensitive interlayer containing the silane coupling agent, the silane coupling agent acts on only the interface between the photosensitive layer and the substrate, and tetravalent silicon atom in the silane coupling agent strongly bonds with the substrate. Accordingly, depending upon the combination of the photosensitive layer and the substrate surface, when compatibility of silane coupling agent to the photosensitive layer is particularly inferior, a large amount of the silane coupling agent is still remained at the non-printing area of the lithographic printing plate obtained through an exposure and development process. Therefore, the part of the other functional group to which the silicon atom of the silane coupling agent is bonded, that is, the part which originally has a function bonding strongly with organic compounds becomes the cause of stain during printing process. Particularly, such an effect was more insufficient for the photopolymerizable photosensitive composition.

### OBJECTS OF THE INVENTION

One object of the present invention is to provide a photopolymerizable composition forming a tough film having excellent adhesion to an aluminum substrate of which hydrophilic nature and water retension characteristic are improved by conducting chemical conversion treatment such as silicate treatment and the like.

Another object is to provide a photosensitive lithographic printing plate having excellent printing durability and storage stability, which cause no stain during printing.

These objects as well as other objects and advantages become apparent to those skilled in the art from the following description.

### SUMMARY OF THE INVENTION

The present inventors have found that the above objects can be accomplished by formulating a silane coupling agent having at least one member selected from the group consisting of vinyl group, acryloyl group and methacryloyl group at a terminal end of the molecule in a photopolymerizable composition, and the present invention has been completed.

That is, according to the present invention, there is provided a photopolymerizable composition comprising (I) a polymerizable compound having an ethylenically unsaturated double bond, (II) a film-forming polymer having alkali-solubility or alkali-swell characteristic and (III) a photopolymerization initiator, said photopolymerizable composition further comprising (IV) a silane coupling agent having at least one member selected from the group consisting of vinyl group, acryloyl group and methacryloyl group at a terminal end of the molecule.

The present invention also provides a photosensitive lithographic printing plate which can be produced by using the above photopolymerizable composition.

### DETAILED DESCRIPTION OF THE INVENTION

The above compound (I) to be formulated in the photopolymerizable composition of the present invention is that polymerized by the action of the photopolymerization initiator (III) to substantially insolubilize the cured article.

As the polymerizable compound (I) having an ethylenically unsaturated double bond, for example, there are unsaturated carboxylic acids such as acrylic acid, methacrylic acid, itaconic acid, maleic acid and the like; esters of polyhydroxy compounds such as ethylene glycol, tetraethylene glycol, neopentyl glycol, propylene glycol, 1,2-butanediol, trimethylolpropane, pentaerythritol, dipentaerythritol and the like with the above unsaturated carboxylic acids; reactants of trimethylolpropane glycidyl ether, pentaerythritol polyglycidyl ether, propylene glycol glycidyl ether and epichlorohydrin with 2,2-bis(4-hydroxyphenyl)-propane; adducts of epoxides such as diglycidyl ester of phthalic acid and the like with the above unsaturated carboxylic acids; acrylamides and methacrylamides such as acrylamide, ethylene bisacrylamide, ethylene bismethacrylamide, hexamethylene bisacrylamide, hexamethylene bismethacrylamide and the like. Among them, acrylic esters or methacrylic esters are preferred.

The above polymer (II) as a binder polymer to be formulated in the photopolymerizable composition of the present invention is that having solubility or swell characteristic to alkaline water, of which non-exposed part being easily removed by a developing solution such as alkaline water and the like. Examples of the polymer (II) include copolymers of (meth)acrylic acid with alkyl (meth)acrylate, (meth)acrylonitrile and the like; copolymers of itaconic acid with alkyl (meth)acrylate, (meth)acrylonitrile and the like; copolymers of crotonic acid with alkyl (meth)acrylate, (meth)acrylonitrile and the like; copolymers of vinyl acetate with alkyl (meth)acrylate; copolymers of partially alkylesterified maleic acid with alkyl (meth)acrylate, (meth)acrylonitrile and the like; copolymers of anhydrous maleic acid with optionally substituted styrene, unsaturated hydrocarbon, unsaturated ether or ester and the like; esterified products of copolymer of anhydrous acid; esterified products of polymer having hydroxyl group with anhydrous dicarboxylic acid or anhydrous polycarboxylic acid; copolymers of hydroxyalkyl (meth)acrylate with alkyl (meth)acrylate, (meth)acrylonitrile and the like; copolymers of aryl alcohol with optionally substituted styrene; copolymers of vinyl alcohol with alkyl (meth)acrylate or other copolymerizable unsaturated compounds; acidic cellulose modified products having carboxyl group at the side chain; polyurethans [provided that these have a sufficient number of free OH groups]; epoxy resins; polyesters; partially oxidized vinyl acetate copolymers; polyvinyl acetals having free OH group; copolymers of hydroxystyrene with alkyl (meth)acrylate and the like; phenol/formaldehide resins; polyethers or polyamides of polyethylene oxide, polyvinyl pyyrolidone or epichlorohydrin with 2,2-bis(4-hydroxyphenyl)propane and the like.

Further, these polymers (II) may have a functional group which is crosslinkable itself, for example, (meth)acryloyl group, cinnamoyl group and the like at the side chain.

The photopolymerization initiator (III) to be formulated in the photopolymerizable composition of the present invention is that causes radical formation by absorbing a light between ultraviolet range and visible range.

Examples thereof include benzophenones such as benzophenone, methyl o-benzoylbenzoate, N,N-tetraetyl-4,4'-diaminobenzophenone, Micheler's ketone, thio-Micheler's ketone and the like; acetophenones such as 2,2-dimethoxyacetophenone, 2,2-diethoxyacetophenone, 2,2-dimethoxy-2-phenylacetophenone, α-hydroxycyclohexyl phenyl ketone, 2-hydroxy-2-methyl-1-phenylpropanone-1,2-methyl-1-[4-(methylthio)phenyl]-2-morpholinopropanone-1 and the like; benzoins such as benzoin, benzoin methyl ether, benzoin isopropyl ether, benzoin isobutyl ether and the like and alkyl ether thereof; ethyl p-dimethylaminobenzoate; ethyl p-diethylaminobenzoate; thioxantones such as thioxanthone, 2-ethylthioxanthone, 2,4-diethylthioxanthone, 2-chlorothioxanthone and the like; 2-ethylanthraquinone; 9-phenylacridine; 9-p-methoxyphenylacridine; 9,10-dimethylbenzphenadine; 6,4,4''-trimethoxy-2,3-diphenylquinoxaline; peroxides such as bezoyl peroxide, di-t-butyl peroxide, dicumyl peroxide, cumenhydro peroxide and the like; 2-nitrofluorene; 2,4,6-triphenylpyryliumboron tetrafluoride; 2,4,6-tris(trichloromethyl)-1,3,5-triazine; N-aryl- α-amino acids such as N-phenylglycine, N-(p-chlorophenyl)glycine and the like; diaryliodonium salts such as diphenyliodonium salt, bis(p-chlorophenyl)iodonium salt and the like. They can be used alone or in combination thereof.

Further, polycyclic aromatic hydrocarbons (e.g. anthracene, phenanthrene, perylene, etc.), coumarine dyes (carbonylbiscoumarine, etc.), common dyes (e.g. rose bengal, eosin, etc.), xanthene or thioxanthene dyes, cyanine or merocyanine dyes and the like can also be used.

The photopolymerizable composition of the present invention is characterized by further containing the silane coupling agent (IV). The silane coupling agent (IV) has at least one member selected from the group consisting of vinyl group, acryloyl group and methacryloyl group at a terminal end of the molecule. Since these groups are present, the silane coupling agent (IV) strongly bonds to the cured article by the exposure curing reaction. Examples of the silane coupling agent (IV) include vinyltrimethoxysilane vinylmethyldimethoxysilane, vinyldimethylmethoxysilane, vinyltriethoxysilane, vinylmethyldiethoxysilane, vinyldimethylethoxysilane, vinyltris(2-methoxyethoxy)silane, vinyltriacetyloxysilane, 3-methacryloxypropyltrimethoxysilane, 3-methacryloxypropylmethyldimethoxysilane and the like. Among them, those having acryloyl group or methacryloyl group at the terminal end are particularly preferred.

In the photopolymerizable composition of the present invention, additives such as thermopolymerization inhibitors, plasticizers, colorlants can be further added.

In the photopolymerizable composition of the present invention, the preferred amount of the polymerizable compound (I), the film-forming polymer (II), the photopolymerization initiator (III) and the silane coupling agent (IV) are 20 to 80 % by weight, particularly 30 to 60 % by weight; 20 to 80 % by weight, particularly 30 to 60 % by weight; 1 to 12 % by weight, particularly 4 to 10 % by weight; 1 to 10 % by weight, particularly 3 to 7 % by weight based on the total weight of the solid content in the composition; respectively. When the amount of the silane coupling agent is less than 1 % by weight, requisite adhesive strength between the substrate and the photosensitive layer can not be obtained. When the amount exceeds 10 % by weight, adhesion between the substrate and the photosensitive layer by the silane coupling agent becomes excessively strong, which results in poor elusion on development or remaining of film. Further, it contains Si and, therefore, ink form characteristic of the printing area is deteriorated.

The photopolymerizable composition of the present invention may be prepared by a normal method. For example, the photopolymerizable composition can be prepared by formulating the above essential components (I) to (IV) as they are, or optionally formulating the components together with a solvent [e.g. ketone solvents such as methyl ethyl ketone, acetone, cyclohexanone, etc.; ester solvents such as ethyl acetate, butyl acetate, ethylene glycol diacetate, etc.; aromatic solvents such as toluene, xylene, etc.; cellosolve solvents such as methyl cellosolve, ethyl cellosolve, butyl cellosolve, etc.; alcohol solvents such as methanol, ethanol, propanol, etc.; ether solvents such as tetrahydrofuran, dioxane, etc.; halogen solvents such as dichloromethane, chloroform, etc.] and mixing them in a dark place, for example, with a high speed mixer.

In the production of the photosensitive lithographic printing plate of the present invention, the photosensitive layer can be formed by applying the above photosensitive composition of the present invention on a substrate, for example, with a bar coater, spinner, etc. and drying according to a normal method. Further, a known technique for protecting the surface and preventing bad influences such as deterioration of sensitivity due to oxygen may be applied to the photosensitive layer formed. For example, a peelable transparent cover sheet or a coating layer made of wax-like substance having low oxygen permeability, water-soluble or alkaline water-soluble polymer, etc. can be provided on the photosensitive layer.

As the above substrate, for example, there are paper, plastic, metal and the like, and metal is preferred. Examples of the metal include aluminum, magnesium, zinc, chromium, iron, nickel and alloy of these metals.

The substrate surface may be flat or roughened. As the method for roughening the surface of the metal substrate, there can be used various conventional methods and example thereof include mechanical methods such as ball grinding method, blush grinding method, etc.; chemical methods such as a method for ethching with a solution containing acid, etc.; electrochemical methods such as a method for ethching by electrolysis, etc.

As the preferred substrate in the present invention, there can be used aluminums. Among them, aluminum of which surface is roughened is preferred. Particularly, that of which roughened surface is further subjected to anodizing treatment and chemical conversion treatment (e.g. silicate treatment, etc.) is preferred.

Then, the above photosensitive layer is irradiated through a negative film, or is cured and insolubilized by laser scanning. As the light source used for light irradiation, there can be used conventional light sources generating visible ray or ultraviolet ray, for example, lasers such as semiconductor laser, helium-neon laser, argon laser and cripton laser, ultrahigh pressure mercury lamp, high pressure mercury lamp, moderated mercury lamp, metal halide lamp, tungsten lamp and the like. Further, in the case of removing the photosensitive layer of the non-exposed part after light irradiation, a commercially available developing solution for offset lithographic printing plate may be used, in addition to an alkaline water such as aqueous sodium methasilicate, aqueous sodium bicarbonate, aqueous triethanolamine, aqueous ammonium and the like.

In the photopolymerizable composition of the present invention, the reaction of polymerizable compound (I) initiates by receiving the action of the photopolymerization initiator (III) according to light irradiation. In that case, acryloyl group, methacryloyl group or vinyl group which is one of the functional group of the silane coupling agent contained in the photopolymerizable composition is incorporated in the reaction system to form the part of the cured film. Further, by hydrolysis of its alkoxy group and the like, the silane coupling agent is converted into silanol, which strongly adheres to the aluminum substrate of which surface has been subjected to hydrophilization treatment, for example, by ether bonding, hydrogen bonding and the like. Such an action is not expected for silicon acrylates, for example. As described above, the photopolymerizable composition containing the silane coupling agent (IV) integrates with the substrate to form a tough cured film.

On the other hand, because of good compatibility of the silane coupling agent to the photosensitive layer, the non-irradiated part is easily removed from the substrate surface by developing treatment while being contained in the photopolymerizable composition. As the result, the photopolymerizable composition containing the above silane coupling agent of the present invention forms a tough film having good adhesion to the aluminum substrate which has sufficiently been subjected to hydrophilization treatment by light irradiation, and can produces a lithographic printing plate having excellent printing durability and storage stability, which cause no stain.

The following Examples and Comparative Examples further illustrate the present invention in detail but are not to be construed to limit the scope thereof.

### Examples 1 to 8 and Comparative Examples 1 to 5

Preparation of photopolymerizable composition and formation of photosensitive lithographic printing plate

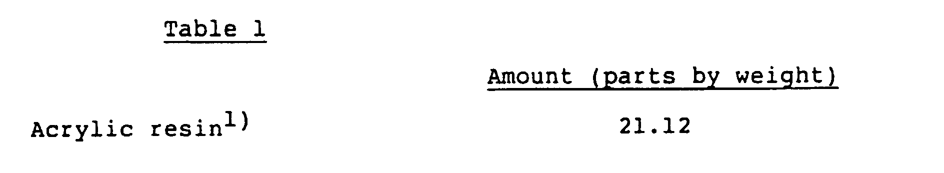

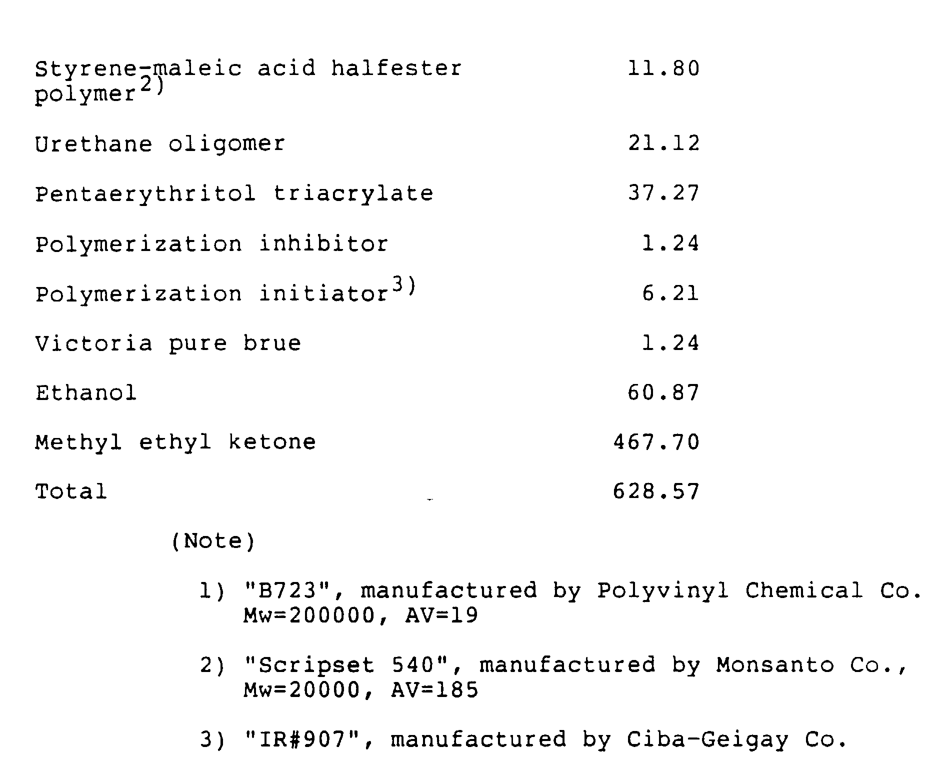

A photosensitive solution of the above formulation shown in Table 1 (628.57 parts) and each silane coupling agent shown in Table 3 hereinafter were mixed while stirring with a high-speed mixer in a dark place to prepare each photopolymerizable composition, respectively.

Then, each photopolymerizable composition described above was applied on an aluminum substrate of which surface has been roughened and subjected to anodizing treatment as well as hydrophilization treatment using a bar coater so that the amount of coating becomes 2 g/m² on drying, and dried in a drying oven at 60°C for 4 minutes. Further, an aqueous 5 % polyvinyl alcohol (saponification degree of 88 %, polymerization degree of 500) was applied on the photosensitive layer using a bar coater so that the amount of coating becomes 2 g/m² on drying, and dried in a drying oven at 60°C for 5 minutes to form an overcoat layer. Then, each photosensitive lithographic printing plate described above was piled with Step Tablet No. 2 (21 steps) manufactured by Kodak Co. and irradiated for 10 seconds with a high pressure mercury lamp (light intensity of 12 mW/cm²) manufactured by Oak Seisakusho K.K. Thereafter, the irradiated plate was developed with a commercially available developing solution for positive photosensitive plate (eight-fold dilute solution of DP-4 manufactured by Fuji Photo Film K.K.) and the number of cured steps was measured. In that case, scratch and peeling of the cured film were observed. The results are shown in Table 3 hereinafter.

### Examples 9 to 16 and Comparative Examples 6 to 10

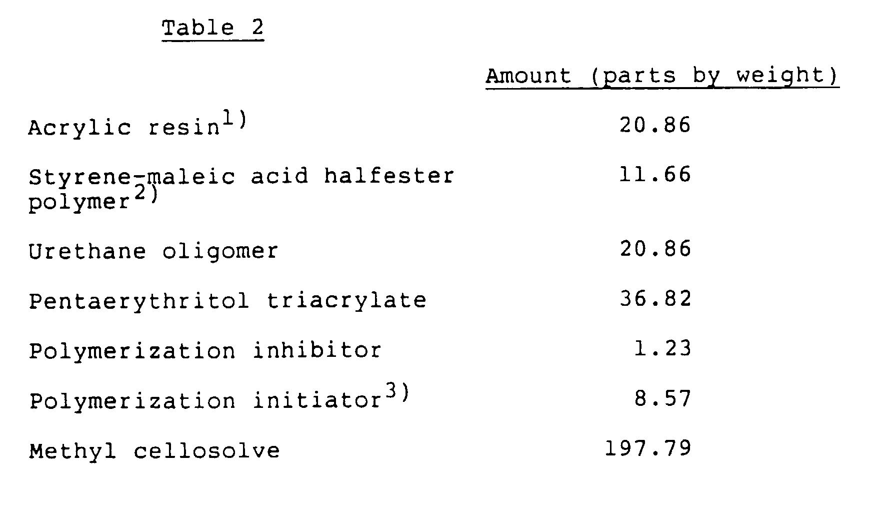

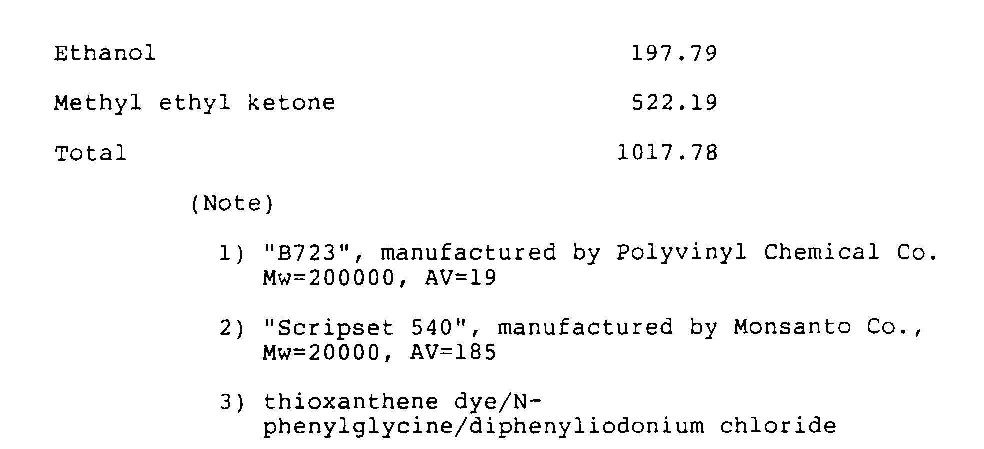

A photosensitive solution of the above formulation shown in Table 2 (1017.78 parts) and each silane coupling agent shown in Table 3 hereinafter were mixed while stirring with a high-speed mixer in a dark place to prepare each photopolymerizable composition, respectively.

Then, each photopolymerizable composition described above was applied on an aluminum substrate of which surface has been roughened and subjected to anodizing treatment as well as hydrophilization treatment using a bar coater so that the amount of coating becomes 2 g/m² on drying, and dried in a drying oven at 60°C for 4 minutes. Further, an aqueous 5 % vinyl alcohol (saponification degree of 88 %, polymerization degree of 500) was applied on the photosensitive layer using a bar coater so that the amount of coating becomes 2 g/m² on drying, and dried in a drying oven at 60°C for 5 minutes to form an overcoat layer. Then, each photosensitive lithographic printing plate described above was piled with Step Tablet No. 2 (21 steps) manufactured by Kodak Co. and irradiated for 3 seconds with the light (light intensity of 4.4 mW/cm²) having a wavelength of 490 nm which was taken out from a xenone lamp (150 W) manufactured by Ushio Denki K.K. through TOSHIBA KL-49 filter. Thereafter, the irradiated plate was developed with a commercially available developing solution for positive photosensitive plate (eight-fold dilute solution of DP-4 manufactured by Fuji Photo Film K.K.) and the number of cured steps was measured. In that case, scratch and peeling of the cured film were observed. The results are shown in Table 3 hereinafter.

### Storage stability test on photosensitive lithographic printing plate

Each photosensitive plate obtained in Examples 15 and 16 and Comparative Example 6 was stored at 40°C in a dark place, respectively. Then, according to the same manner as that described above, they were exposed to light and developed. As a result, regarding photosensitive plates of Examples 15 and 16, no change was observed in developing characteristic and adhesion even after 3 months. The results are shown in Table 4 hereinafter.

### Printing durability test

According to the same manner as that described above, a plate for roll-type (role diameter of 50 mm, manufactured by Nippon Paint K.K.) printing durability test was prepared except that each photosensitive plate obtained in Example 16 and Comparative Example 6 was exposed to light and developed through a negative film (65 to 110 lpi, half tone of 3 to 95 %) instead of Step Tablet No. 2. By using the above test plate, printing durability test (10000 cycles) was conducted with feeding developing ink SPO-1 manufactured by Konica K.K. on the plate under the condition of bite of 0.1 mm. Regarding the plate of Comparative Example 6, 3 to 50 % highlight dots were lost at any screen ruling. On the other hand, regarding the plate of Example 16, all dots were remained. The results are shown in Table 5 hereinafter.

### Printability test

According to the same manner as that described above, each photosensitive plate obtained in Example 16 and Comparative Example 6 was exposed to light and developed to form suitable image, and then printability test was conducted. A printer (Hamadastar 700CDX, manufactured by Hamada Insatsuki Seizosho K.K.), a high-quality paper, ink (non-skin type, manufactured by Mitsubosi Ink K.K.) and a blanket (compression type, manufactured by Danlop Co.) were used, respectively. As a result, regarding the plate of Comparative Example 6, loss of the printing area began when about 5000 sheets of paper were printed. On the other hand, regarding the plate of Example 16, no loss of the image and stain of the non-printing area were observed until 100000 sheets of paper were printed, and good printed article was obtained.

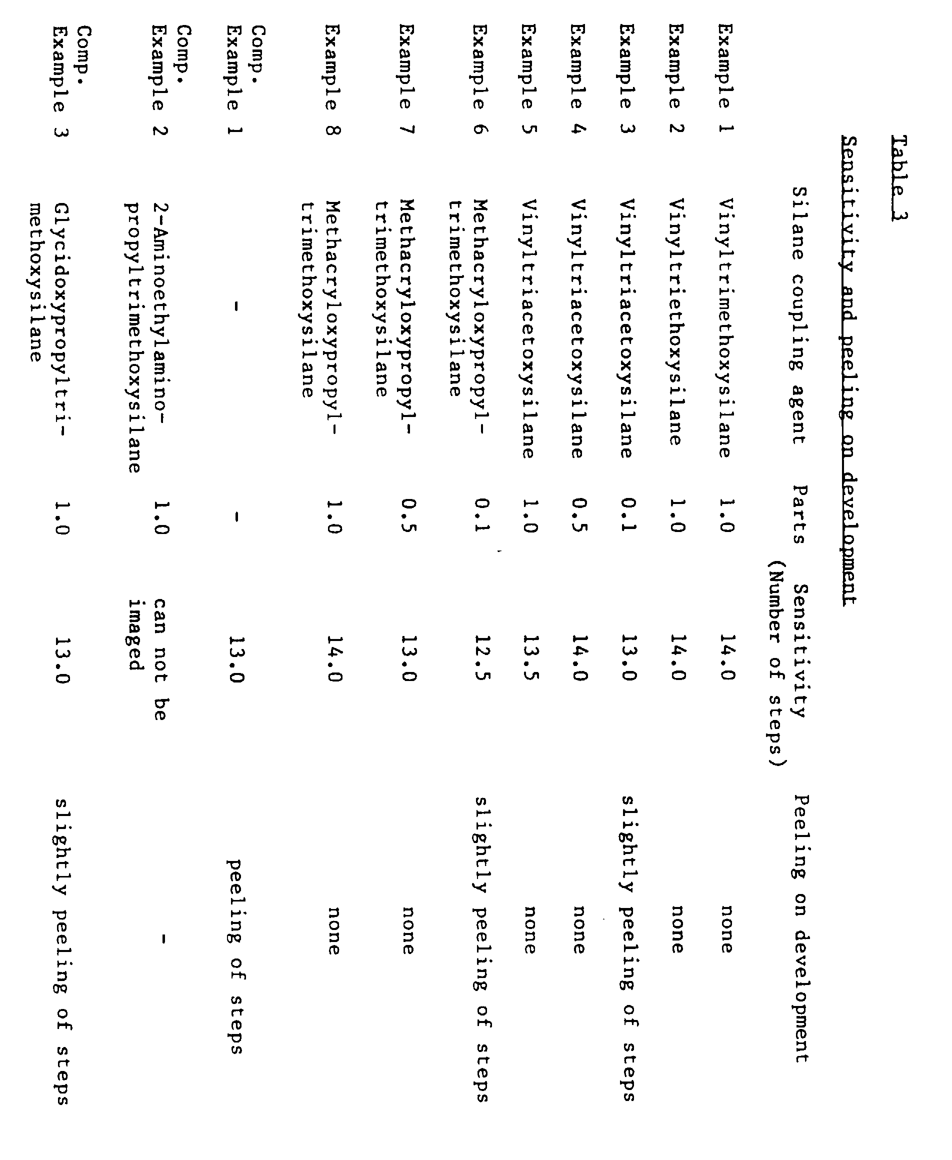

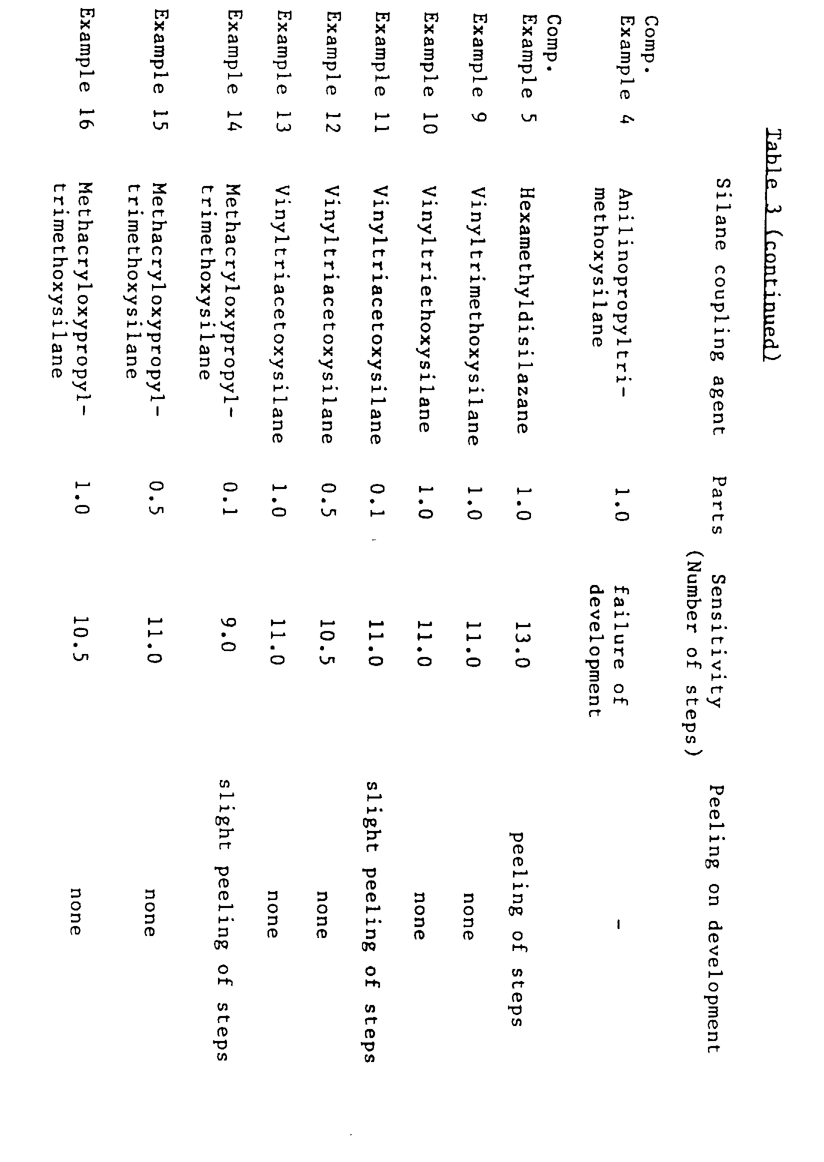

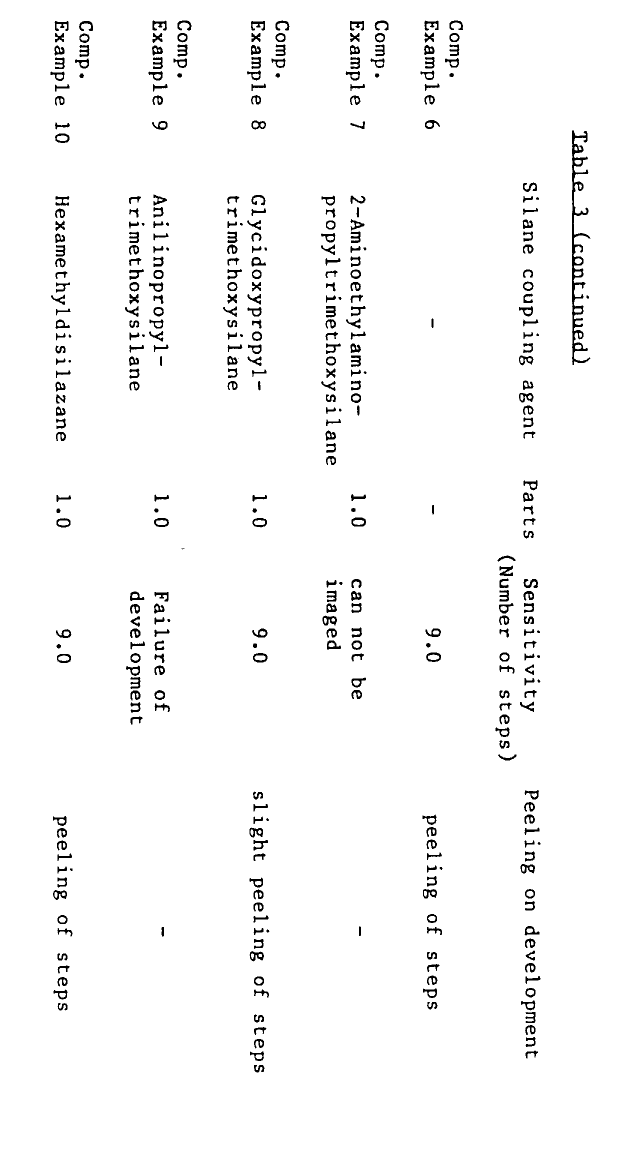

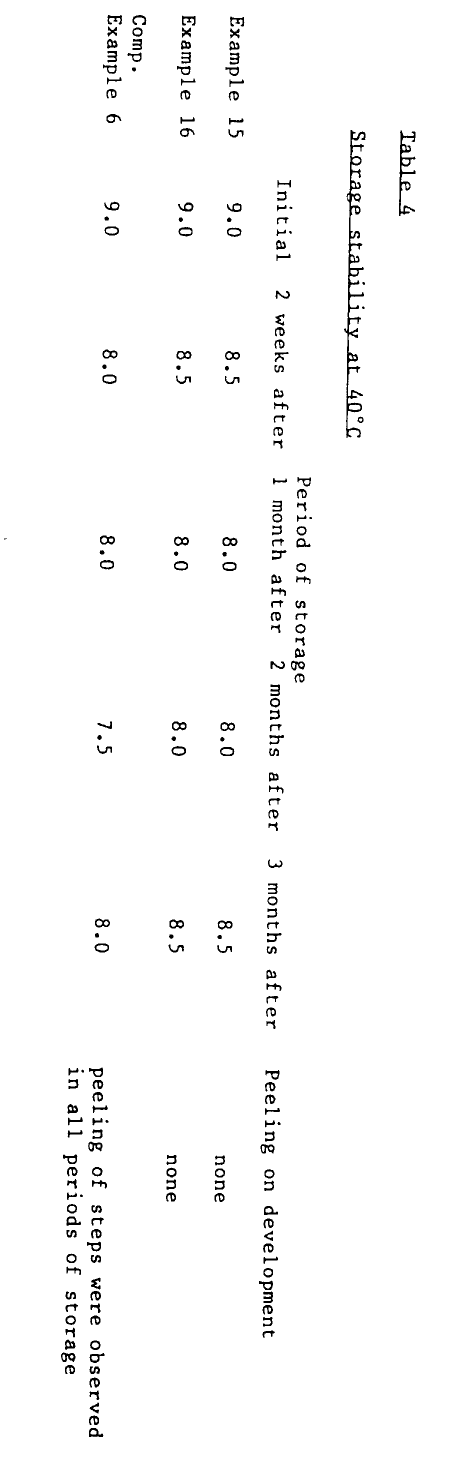

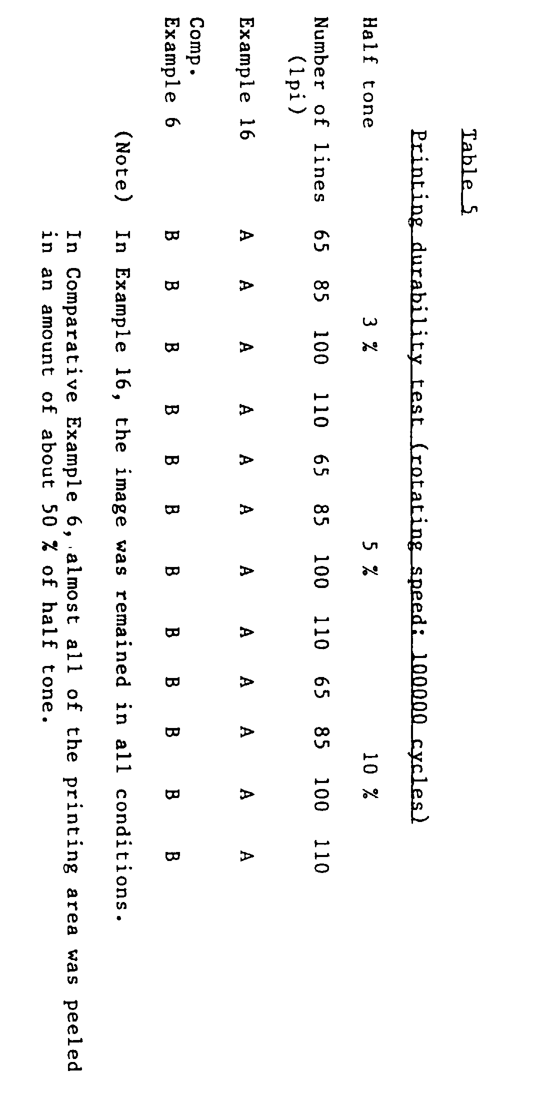

## Claims

1. A photopolymerizable composition comprising (I) a polymerizable compound having an ethylenically unsaturated double bond, (II) a film-forming polymer having alkali-solubility or alkali-swell characteristic and (III) a photopolymerization initiator, said photopolymerizable composition further comprising (IV) a silane coupling agent having at least one member selected from the group consisting of vinyl group, acryloyl group and methacryloyl group at a terminal end of the molecule.

2. The photopolymerizable composition according to claim 1, wherein said silane coupling agent (IV) is present in an amount of 1 to 10 % by weight based on the total weight of the solid content of the photopolymerizable composition.

3. A photosensitive lithographic printing plate comprising the photopolymerizable composition according to claim 1 as a photosensitive layer and an aluminum plate as a substrate.

4. The photosensitive lithographic printing plate according to claim 3, wherein an overcoat layer is formed on the photosensitive layer.

## Patentansprüche

1. Photopolymerisierbare Zusammensetzung, die (I) eine polymerisierbare Verbindung mit einer ethylenisch ungesättigten Doppelbindung, (II) ein filmbildendes Polymer mit Alkali-Löslichkeit oder Alkali-Quelleigenschaft und (III) einen Photopolymerisationsstarter umfaßt, wobei besagte photopolymerisierbare Zusammensetzung weiter (IV) ein Silan-Kupplungsmittel umfaßt, das mindestens ein Mitglied, ausgewählt aus der Gruppe bestehend aus einer Vinyl-Gruppe, eine Acryloyl-Gruppe und einer Methacryloyl-Gruppe an einem terminalen Ende des Moleküls aufweist.

2. Photopolymerisierbare Zusammensetzung gemäß Anspruch 1, worin besagtes Silan-Kupplungsmittel (IV) in einer Menge von 1 bis 10 Gew.-%, bezogen auf die Gesamtmenge des Feststoffgehalts der photopolymerisierbaren Zusammensetzung vorliegt.

3. Lichtempfindliche lithographische Druckplatte, die die photopolymerisierbare Zusammensetzung gemäß Anspruch 1 als lichtempfindliche Schicht und eine Aluminiumplatte als Substrat umfaßt.

4. Lichtempfindliche lithographische Druckplatte gemäß Anspruch 3, worin eine Überzugsschicht auf der lichtempfindlichen Schicht gebildet ist.

## Revendications

1. Composition photopolymérisable comprenant (I) un composé polymérisable ayant une double liaison éthyléniquement insaturée, (II) un polymère filmogène ayant la caractéristique d'être soluble dans des conditions alcalines ou de gonfler dans des conditions alcalines et (III) un amorceur de photopolymérisation, ladite composition photopolymérisable comprenant en outre (IV) un agent de couplage silane ayant au moins un membre choisi dans le groupe constitué par un groupe vinyle, un groupe acryloyle et un groupe méthacryloyle à une extrémité terminale de la molécule.

2. Composition photopolymérisable selon la revendication 1, dans laquelle ledit agent de couplage silane (IV) est présent en une proportion de 1 à 10 % en poids par rapport au poids total de la teneur en substances solides de la composition photopolymérisable.

3. Plaque d'impression lithographique photosensible comprenant la composition photopolymérisable selon la revendication 1 en tant que couche photosensible et une plaque d'aluminium en tant que support.

4. Plaque d'impression lithographique photosensible selon la revendication 3, dans laquelle une couche de recouvrement est formée sur la couche photosensible.
